# EUROPÄISCHE PATENTSCHRIFT

(11) **EP 3 175 684 B1**
(45) Veröffentlichungstag und Bekanntmachung des Hinweises auf die Patenterteilung: **08.01.2020**
(21) Anmeldenummer: 15736195.7
(22) Anmeldetag: 08.07.2015
(51) Int. Cl.: H05K 5/02, H05K 7/14

(54) **ELEKTROGERÄT, INSBESONDERE UMRICHTER**
ELECTRIC DEVICE, IN PARTICULAR CONVERTER
APPAREIL ÉLECTRIQUE, EN PARTICULIER CONVERTISSEUR

(30) Priorität: 30.07.2014 DE 102014011083
(43) Veröffentlichungstag der Anmeldung: 07.06.2017
(73) Patentinhaber: SEW-EURODRIVE GmbH & Co. KG, 76646 Bruchsal (DE)
(72) Erfinder: OTT, Jürgen, 76706 Dettenheim (DE); MOMANN, Dirk, 76646 Bruchsal (DE)
(86) Internationale Anmeldenummer: PCT/EP2015/001386
(87) Internationale Veröffentlichungsnummer: WO 2016/015817

(56) Entgegenhaltungen:
- EP-A2- 1 944 845
- EP-A2- 1 956 685
- GB-A- 442 364
- US-B1- 6 314 772

## Beschreibung

Die Erfindung betrifft ein Elektrogerät, insbesondere Umrichter.

Aus der DE 10 2011 119 490 A1 ist ein Elektrogerät, insbesondere Umrichter, mit einem Deckelteil bekannt.

**Die** GB 442 364 A **zeigt eine Box, die mittels einer Drehverbindung mit einem Abdeckteil verbunden ist.**

**Aus der** EP 1 944 845 A2 **ist eine elektrische Anschlussbox bekannt.**

**Die** US 6 314 772 B1 **zeigt einen Verschlussmechanismus für einen manuellen Feuermelder.**

**Aus der** EP 1 956 685 A2 **ist ein Installationsgerät mit einem kappenartigen Klappdeckel bekannt.**

Der Erfindung liegt daher die Aufgabe zugrunde, ein Elektrogerät weiterzubilden, wobei die Sicherheit verbessert werden soll.

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Umrichter, aufweisend ein Gehäuse und ein Deckelteil, sind, dass
das Deckelteil an dem Gehäuse des Elektrogerätes schwenkbar gelagert ist,
wobei das Deckelteil in einer ersten Schwenkwinkelposition lösbar ist vom Gehäuse,
wobei das Deckelteil in einer zweiten Schwenkwinkelposition verriegelbar ist am Gehäuse,

indem das Deckelteil einen Zapfen aufweist, der in einem Lagerabschnitt, insbesondere einer Vertiefung, des Gehäuses aufgenommen ist,
wobei der Zapfen in einer Querrichtung zur Schwenkachsrichtung weiter ausgedehnt ausgeformt ist als in einer zur Querrichtung und zur Schwenkachsrichtung senkrechten Richtung.

Von Vorteil ist dabei, dass das Deckelteil in einfacher Art und Weise lösbar ist von dem Gehäuse, indem das Deckelteil in die zweite Schwenkwinkelposition geschwenkt wird. Vorteilhafterweise ist dabei ein versehentliches Lösen des Deckelteils vermeidbar, da das Deckelteil in einem großen Schwenkwinkelbereich schwenkbar ist ohne lösbar zu sein. Somit sind von dem Deckelteil abdeckbare Teile des Elektrogerätes inspizierbar bei mit dem Gehäuse verbundenem Deckelteil.

Von Vorteil ist weiter, dass Anzeigemittel, Schalter, Steckverbinder und/oder Gegensteckverbinder am Elektrogerät abdeckbar sind mittels des Deckelteils. Somit ist die Sicherheit des Elektrogerätes verbessert, da eine Fehlbedienung bei geschlossenem Deckelteil verhinderbar ist.

Bei einer vorteilhaften Ausgestaltung weist der Lagerabschnitt einen Einführbereich und einen Drehbereich auf, wobei der Zapfen in der Querrichtung weiter ausgedehnt ist als der Einführbereich in einer zu einer Einführrichtung des Einführbereichs senkrechten Richtung, wobei in der ersten Schwenkwinkelposition die Querrichtung des Zapfens parallel ist zur Einführrichtung. Von Vorteil ist dabei, dass der Zapfen nur in der ersten Schwenkwinkelposition einführbar ist in den Einführbereich des Lagerabschnitts. Somit ist das Deckelteil nur in der ersten Schwenkwinkelposition lösbar von dem Gehäuse. Somit ist ein versehentliches Lösen des Deckelteils vermeidbar.

Der Lagerabschnitt ist in einfacher Art und Weise herstellbar, in dem er in das Gehäuse einfräsbar ist oder in einem Arbeitsgang mit dem Gehäuse als Gussteil, insbesondere Kunststoffspritzgussteil, herstellbar ist.

Bei einer vorteilhaften Ausgestaltung ist der Drehbereich als runde Vertiefung ausgeführt. Von Vorteil ist dabei, dass der Zapfen im Drehbereich drehbar ist. Vorteilhafterweise ist die Drehreibung des Zapfens reduzierbar, so dass der Verschleiß reduzierbar ist. Somit ist die Sicherheit verbessert.

Bei einer vorteilhaften Ausgestaltung ist der Zapfen ebenfalls rund ausgeführt, so dass ein Verkanten des Zapfens in dem Lagerabschnitt vermeidbar ist.

Bei einer vorteilhaften Ausgestaltung erstreckt sich der Drehbereich radial weiter als der Einführbereich in der zur Einführrichtung senkrechten Richtung. Von Vorteil ist dabei, dass der Zapfen nur in der ersten Schwenkwinkelposition durch den Einführbereich bewegbar ist. Im Drehbereich ist der Zapfen beliebig drehbar, so dass das Deckelteil in beliebige Schwenkwinkelpositionen schwenkbar ist.

Bei einer vorteilhaften Ausgestaltung ist der Einführbereich in der Einführrichtung zum Drehbereich hin und zur Umgebung hin offen ausgeführt. Von Vorteil ist dabei, dass der Zapfen von der Umgebung durch den Einführbereich in den Drehbereich einführbar ist, wenn das Deckelteil in der zweiten Schwenkwinkelposition positioniert ist.

Bei einer vorteilhaften Ausgestaltung weist das Deckelteil einen Grundkörper und einen Gelenkabschnitt auf, der aus dem Grundkörper auskragt, wobei der Zapfen an dem Gelenkabschnitt angeordnet ist und beabstandet ist vom Grundkörper, insbesondere wobei Grundkörper, Zapfen und Gelenkabschnitt einstückig ausgeführt sind, insbesondere als Kunststoffspritzgussteil. Von Vorteil ist dabei, dass der verfügbare Schwenkwinkelbereich des Deckelteils vergrößerbar ist mittels des aus dem Grundkörper auskragenden Gelenkabschnitts. Die Schwenkachse des Deckelteils erstreckt sich durch den Gelenkabschnitt hindurch, insbesondere durch den Zapfen hindurch.

Bei einer vorteilhaften Ausgestaltung weist das Gehäuse eine Gelenkaufnahme auf, wobei der Gelenkabschnitt des Deckelteils in der Gelenkaufnahme aufgenommen ist und in axialer Richtung begrenzt ist von der Gelenkaufnahme. Von Vorteil ist dabei, dass der Gelenkabschnitt in der Gelenkaufnahme drehbar ist. Vorteilhafterweise ist die Gelenkaufnahme als Vertiefung in dem Gehäuse ausgeführt. Vorteilhafterweise ist eine Außenseite des Deckelteils bündig und/oder in einer Flucht anordenbar mit einer Außenseite des Gehäuses. Somit ist das Verletzungsrisiko für einen Bediener des Elektrogerätes reduzierbar.

Die axiale Richtung ist hierbei definiert durch die Drehachse des Deckelteils.

Bei einer vorteilhaften Ausgestaltung ist der Lagerabschnitt als Vertiefung in der Gelenkaufnahme ausgeführt. Von Vorteil ist dabei, dass der Gelenkabschnitt in der Gelenkaufnahme drehbar ist.

Bei einer vorteilhaften Ausgestaltung ist die Gelenkaufnahme als gestufte Vertiefung ausgeführt. Von Vorteil ist dabei, dass die Gelenkaufnahme in einfacher Art und Weise fertigbar ist, beispielsweise mittels Fräsen. Vorteilhafterweise ist die Gelenkaufnahme in einem Arbeitsgang mit einem die Gelenkaufnahme aufweisenden Gehäuseteil fertigbar, beispielsweise als Kunststoffspritzgussteil.

Bei einer vorteilhaften Ausgestaltung weist das Elektrogerät ein Verriegelungsmittel zum Verriegeln des Deckelteils auf, insbesondere wobei das Deckelteil verriegelbar ist am Gehäuse mittels des Verriegelungsmittels. Von Vorteil ist dabei, dass ein unbeabsichtigtes Öffnen des Deckelteils vermeidbar ist. Beim Transport und/oder Einbau des Elektrogerätes sind Steckverbinder und/oder Anzeigemittel am Elektrogerät abdeckbar mittels des Deckelteils und vor Beschädigung schützbar.

Bei einer vorteilhaften Ausgestaltung ist das Verriegelungsmittel am Gehäuse drehbar gelagert um eine Drehachse, wobei das Verriegelungsmittel einen Verbreiterungsabschnitt aufweist, der unrund ausgeführt ist. Von Vorteil ist dabei, dass das Deckelteil mittels des unrunden Verbreiterungsabschnitts am Gehäuse verriegelbar und entriegelbar ist. Das Verriegelungsmittel ist vorteilhafterweise als Schraube ausführbar. Der Schraubenkopf der Schraube ist unrund ausführbar und fungiert als Verbreiterungsabschnitt.

Bei einer vorteilhaften Ausgestaltung weist das Verriegelungsmittel einen, insbesondere exzentrisch zur drehbaren Lagerung des Verriegelungsmittels am Gehäuse, herausragenden Nasenabschnitt auf, der beabstandet ist vom Gehäuse. Von Vorteil ist dabei, dass der Nasenabschnitt zum Verriegeln des Deckelteils als axiales Begrenzungsmittel für einen Vorsprung des Deckelteils wirkt. Der Vorsprung ist dabei zwischen dem Nasenabschnitt und dem Gehäuse anordenbar.

Alternativ ist der Nasenabschnitt in eine Ausnehmung in dem Deckelteil einführbar und ausführbar.

Bei einer vorteilhaften Ausgestaltung ist das Verriegelungsmittel zumindest in eine erste oder eine zweite Position drehbar, wobei das Deckelteil in der ersten Position des Verriegelungsmittels verriegelt ist und wobei das Deckelteil in der zweiten Position des Verriegelungsmittels entriegelt ist. Von Vorteil ist dabei, dass das Deckelteil reversibel am Gehäuse verriegelbar ist. Vorteilhafterweise ist die erste Position gut erkennbar, so dass eine sichere Verriegelung ausführbar ist.

Bei einer vorteilhaften Ausgestaltung ist am Gehäuse und/oder dem Deckelteil zumindest ein Begrenzungsmittel ausgeformt oder verbunden, welches die Drehbewegung des Verriegelungsmittels in beziehungswiese entgegen der Umfangsrichtung begrenzt. Von Vorteil ist dabei, dass das Begrenzungsmittel als Anschlag fungiert für das Verriegelungsmittel. Vorteilhafterweise ist das Verriegelungsmittel in die erste Position drehbar und wird dort von dem Begrenzungsmittel begrenzt. Somit ist die erste Position des Verriegelungsmittels in einfacher Art und Weise blind einstellbar. Eine optische Überprüfung der Position des Verriegelungsmittels ist also verzichtbar.

Bei einer vorteilhaften Ausgestaltung weist das Gehäuse und/oder das Deckelteil ein erstes Begrenzungsmittel auf, wobei das Verriegelungsmittel in der ersten Position von dem ersten Begrenzungsmittel begrenzt ist. Von Vorteil ist dabei, dass mittels des ersten Begrenzungsmittels die erste Position des Verriegelungsmittels anzeigbar beziehungsweise erkennbar ist. Vorteilhafterweise wird das Verriegelungsmittel derart von dem ersten Begrenzungsmittel begrenzt, dass das Deckelteil sicher verriegelt ist.

Bei einer vorteilhaften Ausgestaltung weist das Gehäuse und/oder das Deckelteil ein zweites Begrenzungsmittel auf, wobei das Verriegelungsmittel in der zweiten Position von dem zweiten Begrenzungsmittel begrenzt ist. Von Vorteil ist dabei, dass mittels des zweiten Begrenzungsmittels die zweite Position des Verriegelungsmittels anzeigbar beziehungsweise erkennbar ist. Vorteilhafterweise wird das Verriegelungsmittel derart von dem zweiten Begrenzungsmittel begrenzt, dass das Deckelteil sicher entriegelt ist.

Bei einer vorteilhaften Ausgestaltung sind das erste und zweite Begrenzungsmittel einstückig ausgeführt. Von Vorteil ist dabei, dass die Begrenzungsmittel in einfacher Art und Weise herstellbar sind.

Bei einer vorteilhaften Ausgestaltung ist das Verriegelungsmittel in einer ersten Drehrichtung in die erste Position verdrehbar und in einer zweiten Drehrichtung in die zweite Position verdrehbar, wobei die erste und zweite Drehrichtung einander entgegengesetzt sind. Von Vorteil ist dabei, dass mittels der Drehrichtung und des Begrenzungsmittels eindeutig die Position des Verriegelungsmittels anzeigbar ist.

Bei einer vorteilhaften Ausgestaltung weist das Deckelteil einen Vorsprung auf, wobei der Vorsprung in der ersten Position des Verriegelungsmittels zumindest teilweise zwischen dem Gehäuse und dem Nasenabschnitt angeordnet ist. Von Vorteil ist dabei, dass der Vorsprung zwischen dem Gehäuse und dem Nasenabschnitt axial begrenzbar ist, somit ist das Deckelteil sicher verriegelbar.

Bei einer vorteilhaften Ausgestaltung überdeckt in der ersten Position des Verriegelungsmittels die axiale Projektion des Nasenabschnitts relativ zur Drehachse des Verriegelungsmittels, die axiale Projektion des Vorsprungs relativ zur Drehachse des Verriegelungsmittels zumindest teilweise. Von Vorteil ist dabei, dass der Vorsprung zwischen dem Gehäuse und dem Nasenabschnitt axial begrenzbar ist, somit ist das Deckelteil sicher verriegelbar.

Vorteilhafterweise ist die Schwenkrichtung des Deckelteils in der zweiten Schwenkwinkelposition parallel zur Drehachse des Verriegelungsmittels.

Bei einer vorteilhaften Ausgestaltung ist der Vorsprung in der zweiten Position des Verriegelungsmittels von dem Nasenabschnitt in radialer Richtung relativ zur Drehachse des Verriegelungsmittels beabstandet. Von Vorteil ist dabei, dass das Deckelteil in der zweiten Position des Verriegelungsmittels schwenkbar ist, insbesondere nicht blockiert ist.

Bei einer vorteilhaften Ausgestaltung weist das Deckelteil eine erste Ausnehmung auf, die mit einem Abdeckteil verschließbar ist, wobei das Deckelteil mit dem Abdeckteil lösbar verbunden ist, insbesondere klipsverbunden, wobei das Abdeckteil in der zweiten Schwenkwinkelposition das Verriegelungsmittel abdeckt. Von Vorteil ist dabei, dass eine unbeabsichtigte Betätigung des Verriegelungsmittels verhinderbar ist. Somit ist ein unbeabsichtigtes Öffnen des Deckelteils verhinderbar. Die Sicherheit des Elektrogeräts ist verbessert.

Bei einer vorteilhaften Ausgestaltung deckt das Abdeckteil in der zweiten Schwenkwinkelposition ein Steckverbinderteil ab. Von Vorteil ist dabei, dass das Steckverbinderteil vor unbeabsichtigtem Kontakt schützbar ist. So sind beispielsweise Spannungsüberschläge durch elektrostatische Aufladung bei elektrischen Steckverbinderteilen vermeidbar.

Bei einer vorteilhaften Ausgestaltung weist das Gehäuse ein Einschubführungsteil auf, in das ein Typenschild einschiebbar ist, wobei das Deckelteil eine Nut aufweist, wobei in der zweiten Schwenkwinkelposition das Typenschild in der Nut angeordnet, insbesondere aufgenommen, ist. Von Vorteil ist dabei, dass das Deckelteil zusätzlich verriegelbar ist mittels des eingeschobenen Typenschildes, insbesondere als zusätzliche Verriegelung zu dem Verriegelungsmittel. Vorteilhafterweise ist die Nut passgenau für das Typenschild ausführbar, so dass eine formschlüssige Verbindung des Typenschildes mit dem Deckelteil herstellbar ist.

Bei einer vorteilhaften Ausgestaltung ist ein Gehäuseteil des Gehäuses mit dem Einschubführungsteil verbunden, wobei das Gehäuseteil als Metallteil ausgeführt ist und/oder das Typenschild und/oder das Einschubführungsteil als Kunststoffteil ausgeführt sind. Von Vorteil ist dabei, dass das Typenschild gleitlagerbar ist in dem Einschubführungsteil. Vorteilhafterweise weisen das Typenschild und das Einschubführungsteil ähnliche mechanische Eigenschaften auf, so dass beim Einschieben des Typenschildes in das Einschubführungsteil beide Kunststoffteile vorwiegend elastisch verformbar sind.

Bei einer vorteilhaften Ausgestaltung ist ein Bedienteil lösbar mit dem Gehäuse verbunden, insbesondere klipsverbunden, wobei das Deckelteil eine zweite Ausnehmung aufweist, durch die das Bedienteil hindurchbedienbar ist, wobei das Deckelteil das Bedienteil am Gehäuse sichert, insbesondere hält. Von Vorteil ist dabei, dass das Bedienteil in einfacher Art und Weise austauschbar ist. Mittels des Deckelteils ist ein unbeabsichtigtes Lösen des Bedienteils verhinderbar.

Bei einer vorteilhaften Ausgestaltung weist das Deckelteil eine dritte Ausnehmung auf, wobei am Elektrogerät ein weiteres Steckverbinderteil angeordnet ist, das durch die dritte Ausnehmung hindurch zugänglich ist, insbesondere für ein Gegensteckverbinderteil, insbesondere so dass das Gegensteckverbinderteil zur Verbindung mit dem weiteren Steckverbinderteil durch die dritte Ausnehmung hindurch führbar ist und steckverbindbar ist mit dem Steckverbinderteil, insbesondere in der zweiten Schwenkwinkelposition. Von Vorteil ist dabei, dass eine Steckverbindung des Steckverbinders mit dem Gegensteckverbinder auch bei geschlossenem Deckelteil in einfacher Art und Weise herstellbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein erfindungsgemäßes Elektrogerät, insbesondere ein Umrichter 1, in einer ersten Ausführungsform, aufweisend ein geschlossenes Deckelteil 4, in Schrägansicht gezeichnet.
Figur 2 zeigt das erfindungsgemäße Elektrogerät in der ersten Ausführungsform in Schrägansicht, wobei das Deckelteil 4 aufgeklappt ist.
In Figur 3 ist eine Detailansicht des Deckelteils 4 der ersten Ausführungsform gezeigt.
Figur 4 zeigt eine Detailansicht eines entriegelten Verriegelungsmittels 23 für das Deckelteil 4 der ersten Ausführungsform in Schrägansicht.
Figur 5 zeigt eine Detailansicht eines verriegelten Verriegelungsmittels 23 für das Deckelteil 4 der ersten Ausführungsform in Schrägansicht.
In Figur 6 ist eine zweite erfindungsgemäße Ausführungsform des Elektrogerätes mit einem geöffneten Deckelteil 63 dargestellt.
Figur 7 zeigt eine Detailansicht des Deckelteils 63 der zweiten Ausführungsform.
Figur 8 zeigt eine weitere Detailansicht des Deckelteils 63 der zweiten Ausführungsform, wobei das Deckelteil 63 geschlossen ist.
Figur 9 zeigt eine Detailansicht des Deckelteils 63 der zweiten Ausführungsform, wobei das Deckelteil 63 geöffnet ist.

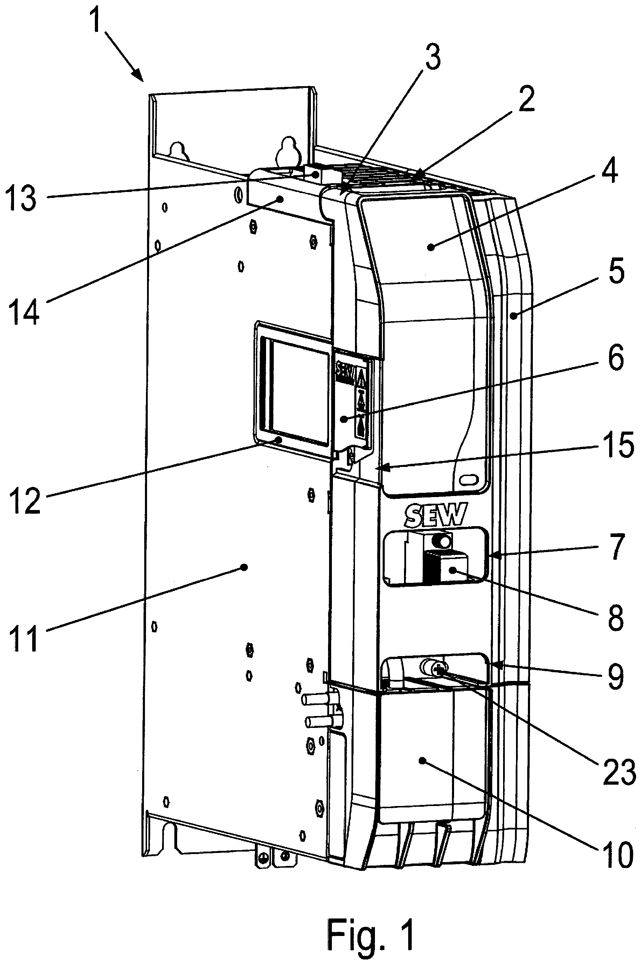

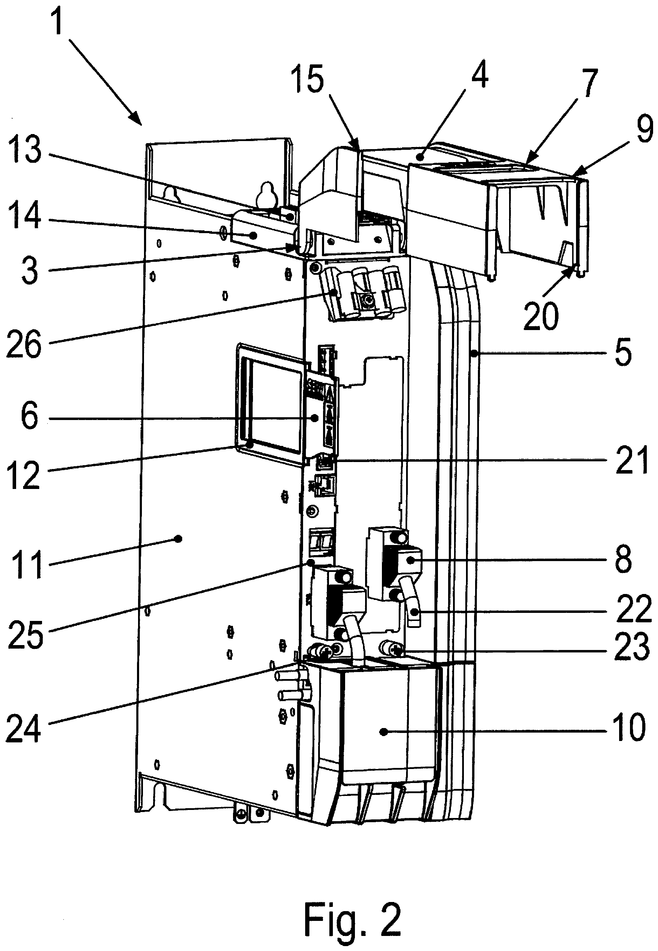

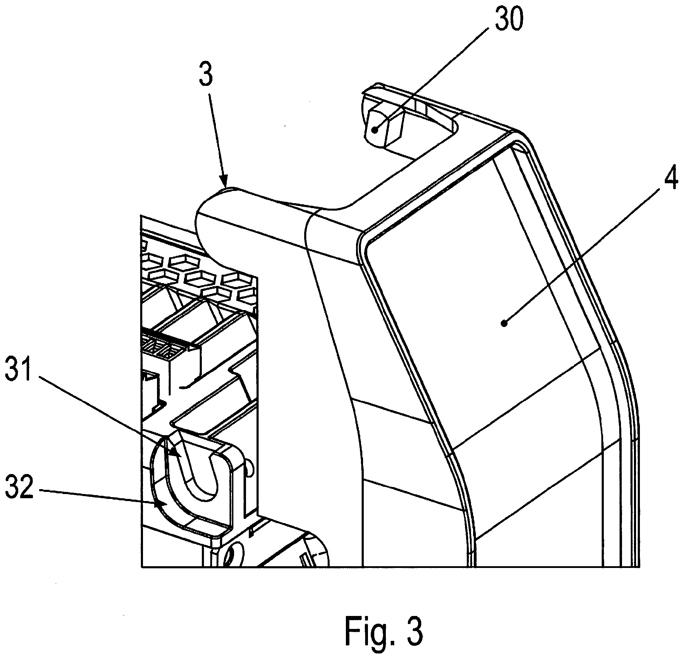

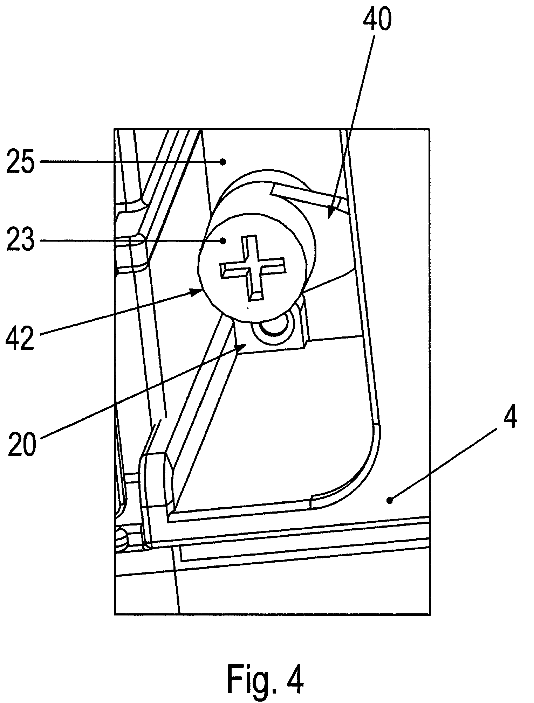

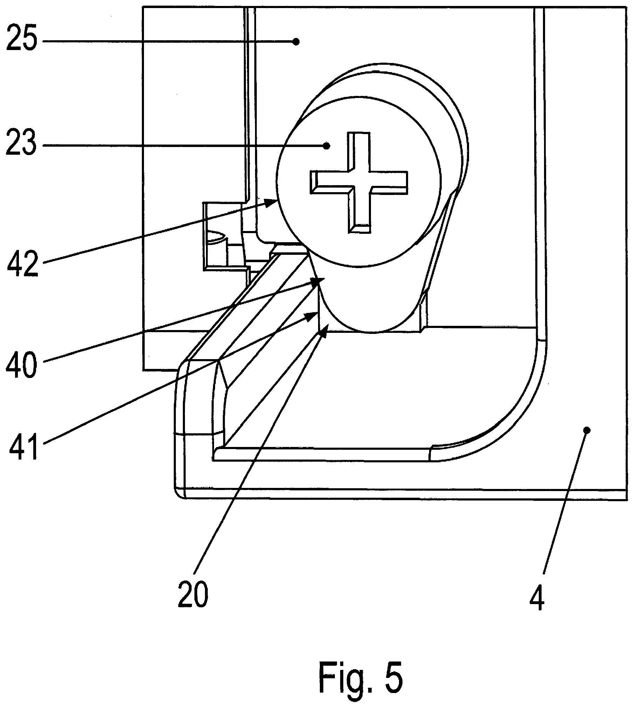

Das in den Figuren 1 bis 5 dargestellte erste Ausführungsbeispiel des Umrichters 1 weist das Deckelteil 4 und ein zumindest ein Gehäuseteil 14 aufweisendes Gehäuse auf, mit dem das Deckelteil 4 schwenkbar und lösbar verbunden ist. Dazu weist das Deckelteil 4 einen Gelenkabschnitt 3 auf. Der Gelenkabschnitt 3 weist einen Zapfen 30 auf, der aus dem Deckelteil 4 auskragt. Dabei fungiert der Zapfen 30 als Gelenkkopf für das Deckelteil 4.

Der Zapfen 30 ist in Querrichtung zur Schwenkrichtung länglich ausgeführt. Vorzugsweise erstreckt sich der Zapfen 30 in einer Einführrichtung des Zapfens 30 weiter als in einer Querrichtung zur Einführrichtung.

Vorzugsweise ist der Zapfen 30 zylindrisch ausgeführt. Vorzugsweise weist die Grundfläche des Zapfens 30 zwei gerade Umfangsabschnitte auf, die parallel ausgeführt sind.

Unter parallel wird hierbei ein Winkelbereich zwischen zwei Geraden verstanden, der kleiner als 40° ist, vorzugsweise kleiner als 30°, besonders bevorzugt kleiner als 20°.

Vorzugsweise ist das Gehäuse mehrteilig ausgeführt und weist Gehäuseteile aus metallischem Material, beispielsweise aus Aluminium, und/oder aus Kunststoff auf, insbesondere Kunststoffspritzgussteile.

Das Gehäuseteil 14 weist einen Lagerabschnitt 31 auf, der in einer Gelenkaufnahme 32 für den Gelenkabschnitt 3 des Deckelteils 4 angeordnet ist. Die Gelenkaufnahme 32 ist als eine mehrstufige Vertiefung ausgeführt. Dabei bildet der Lagerabschnitt 31 eine Stufe der mehrstufigen Vertiefung und erstreckt sich am weitesten in das Gehäuseteil 14 hinein.

Der Zapfen 30 ist in dem Lagerabschnitt 31 gelagert. Vorzugsweise weist der Lagerabschnitt 31 in Querrichtung zur Schwenkrichtung des Deckelteils eine Öffnung auf, durch die der Zapfen 30 in den Lagerabschnitt 31 einführbar ist.

Der Lagerabschnitt 31 weist einen Einführbereich und einen Drehbereich auf. Der Einführbereich erstreckt sich in der Einführrichtung von der Umgebung zum Drehbereich. Dabei ist der Einführbereich zur Umgebung und zum Drehbereich hin offen ausgeführt. Der Drehbereich ist als runde Vertiefung ausgeführt, wobei der Radius des Drehbereichs größer ist als der Einführbereich in Querrichtung zur Einführrichtung.

Vorteilhafterweise weist das Deckelteil 4 zwei Zapfen 30 auf, die eine gemeinsame Schwenkachse aufweisen. Die Zapfen 30 erstrecken sich von einem jeweiligen Gelenkabschnitt 3 des Deckelteils und sind einander gegenüberliegend angeordnet. Das Gehäuseteil 14 ist also axial zwischen den Gelenkabschnitten 3 angeordnet. Die Gelenkaufnahmen 32 für den jeweiligen Zapfen 30 begrenzen die Gelenkabschnitte 3 in axialer Richtung.

An dem Gehäuseteil 14 ist ein Steckverbinderteil 13 angeordnet. Das Gehäuseteil 14 weist Ausnehmungen 2, insbesondere Lüftungsschlitze zur Kühlung des Umrichters 1, auf.

Das Gehäuse des Umrichters 1 weist ein weiteres Gehäuseteil 25 auf. Das Deckelteil 4 ist mit dem weiteren Gehäuseteil 25 lösbar verbindbar mittels zumindest eines Verriegelungsmittels 23, vorzugsweise weist das Elektrogerät zwei Verriegelungsmittel (23, 24) auf.

Vorzugsweise ist das Verriegelungsmittel 23 an einem dem Gelenkabschnitt 3 gegenüberliegenden Endbereich des Deckelteils 4 am Deckelteil 4 verriegelbar.

Das Gehäuseteil 25 ist zumindest teilweise abdeckbar mittels des Deckelteils 4.

Vorzugsweise sind die Verriegelungsmittel (23, 24) jeweils als Schraubteil ausgeführt und weisen jeweils einen Nasenabschnitt 40 auf. Dabei kragt der jeweilige Nasenabschnitt 40 von einem jeweiligen als Verbreiterungsabschnitt 42 fungierenden Schraubenkopf des jeweiligen Verriegelungsmittels (23, 24) aus. Ein jeweiliger Schraubenkopf des jeweiligen Schraubteils ist unrund, insbesondere exzentrisch zur Schraubenachse, ausgeführt.

Zur Verriegelung des Deckelteils 4 am Gehäuseteil 25 weist das Deckelteil 4 zumindest einen Vorsprung 20 auf, der von dem Deckelteil 4 auskragt. Im verriegelten Zustand ist jeweils ein Vorsprung 20 zumindest teilweise zwischen dem jeweiligen Nasenabschnitt 40 und dem Gehäuseteil 25 angeordnet. Der Nasenabschnitt 40 begrenzt den Vorsprung 20, so dass das Deckelteil 4 am Gehäuseteil 25 verriegelt ist.

Vorzugsweise ist das jeweilige Verriegelungsmittel (23, 24) jeweils drehbar an dem Gehäuseteil 25 angeordnet. Dabei ist das Deckelteil 4 mittels Drehen des/der Verriegelungsmittel (23, 24) verriegelbar und/oder entriegelbar. Wird das jeweilige Verriegelungsmittel (23, 24) bei geschlossenem Deckelteil gedreht, so greift der jeweilige Nasenabschnitt 40 über den Vorsprung 20 und verriegelt das Deckelteil 4. Vorzugsweise weist das Deckelteil 4 ein Begrenzungsmittel 41, aufweisend einen jeweiligen ersten Anschlag für den jeweiligen Nasenabschnitt 40, auf, so dass das jeweilige Verriegelungsmittel (23, 24) in einer ersten Drehrichtung bis in eine erste Position verdrehbar ist, in der das Deckelteil 4 verriegelt ist. Zum Entriegeln des Deckelteils 4 wird das jeweilige Verriegelungsmittel (23, 24) in eine zweite Drehrichtung gedreht, die der ersten Drehrichtung entgegengerichtet ist.

Vorzugsweise weist das Deckelteil 4 einen zweiten Anschlag für das jeweilige Deckelteil 4 auf, so dass das jeweilige Verriegelungsmittel (23, 24) in der zweiten Drehrichtung bis in eine zweite Position verdrehbar ist, in der das Deckelteil 4 unverriegelt ist. Vorzugsweise sind der erste und zweite Anschlag als zwei Seiten des Begrenzungsmittels 41 ausgeführt. Alternativ fungiert der Vorsprung 20 am Deckelteil 4 als Begrenzungsmittel 41.

In dem Gehäuseteil 25 ist zumindest ein weiteres Steckverbinderteil 21 zur Verbindung mit einem Gegensteckverbinderteil angeordnet. Beispielsweise ist ein Datenbus, eine Drehspannungsversorgung, ein 24V-Anschluss, ein Motorkabel oder ein Sensorkabel an den Umrichter 1 anschließbar.

An dem Gehäuseteil 25 ist zumindest eine Kabelführung 26 angeordnet. Vorteilhafterweise sind die Kabelführung 26 und das Steckverbinderteil 21 abdeckbar mittels des Deckelteils 4.

Der Umrichter 1 weist ein Abdeckteil 5 auf, das benachbart zu dem Deckelteil 4 angeordnet ist und fest mit dem Gehäuse verbunden ist. Vorzugsweise sind das Abdeckteil 5 und das Deckelteil 4 aus Kunststoff ausgeführt.

Der Umrichter 1 weist ein Einschubführungsteil 12 für ein Typenschild 6 auf. Auf dem Typenschild 6 sind technische Informationen und Warnhinweise aufgebracht. Das Typenschild 6 ist in das Einschubführungsteil 12 einschiebbar und vom Benutzer entnehmbar, so dass die technischen Informationen und Warnhinweise lesbar sind. Vorteilhafterweise erstreckt sich das Einschubführungsteil 12 in einer von einem Gehäuseteil 11 des Gehäuses aufgespannten Ebene.

Das Typenschild 6 und das Einschubführungsteil 12 sind als Kunststoffteile, insbesondere Kunststoffspritzgussteile ausgeführt. Vorzugsweise ist das Typenschild 6 am Einschubführungsteil 12 gleitgelagert. Das Gehäuseteil 11 ist als Metallteil ausgeführt. Beispielsweise ist das Typenschild 6 als Speicherkarte, SD-Karte oder Chipkarte ausführbar und weist computerlesbare technische Informationen auf, die mittels eines mit einem Computer verbundenen Lesegeräts lesbar sind.

Das Deckelteil 4 weist eine Nut 15 auf. Bei geschlossenem Deckelteil 4 ist das Typenschild 6 von der Nut 15 geführt in das Einschubführungsteil 12 einschiebbar und/oder in der Nut 15 aufgenommen.

Das Deckelteil 4 weist zumindest eine Ausnehmung 9 auf, durch welche ein Werkzeug, insbesondere ein Schraubendreher, zur Bedienung der Verriegelungsmittel (23, 24) hindurchführbar ist.

Mit dem Umrichter 1 ist ein Gegensteckverbinderteil 8 verbindbar. Vorzugsweise ist das Gegensteckverbinderteil 8 mittels des Deckelteils 4 teilweise einhausbar. Vorzugsweise weist das Deckelteil 4 eine weitere Ausnehmung 7 auf, durch die ein in den Figuren nicht dargestelltes Anzeigemittel des Umrichters 1 sichtbar ist, insbesondere ein Display oder eine Siebensegmentanzeige.

Der Umrichter 1 weist eine Kabelführung 10 auf, mittels der ein mit dem Gegensteckverbinderteil 8 verbundenes Kabel 22 geführt ist.

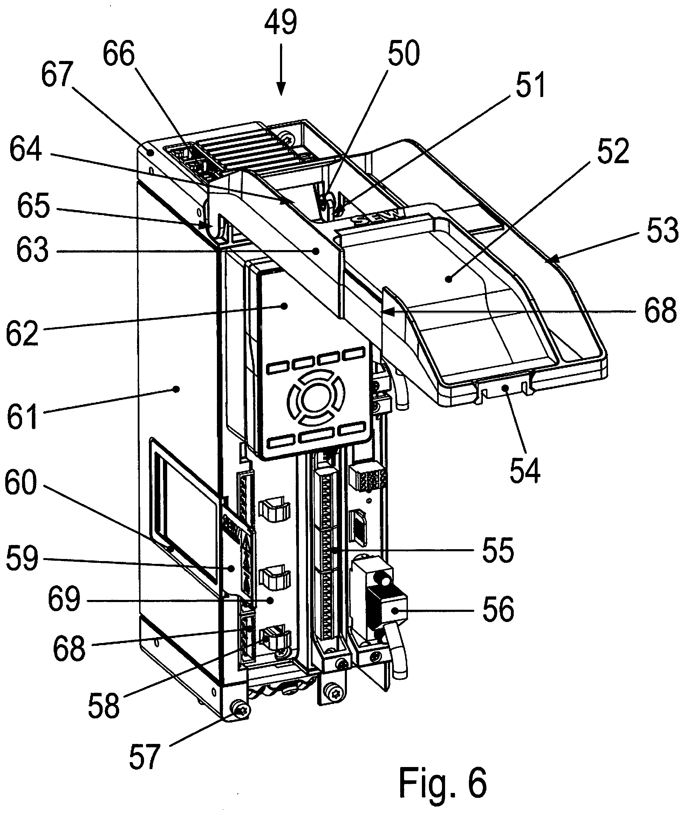

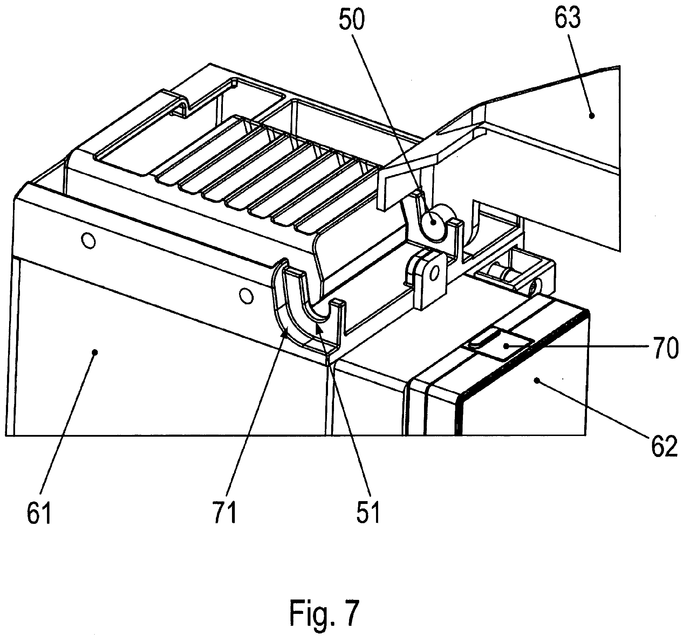

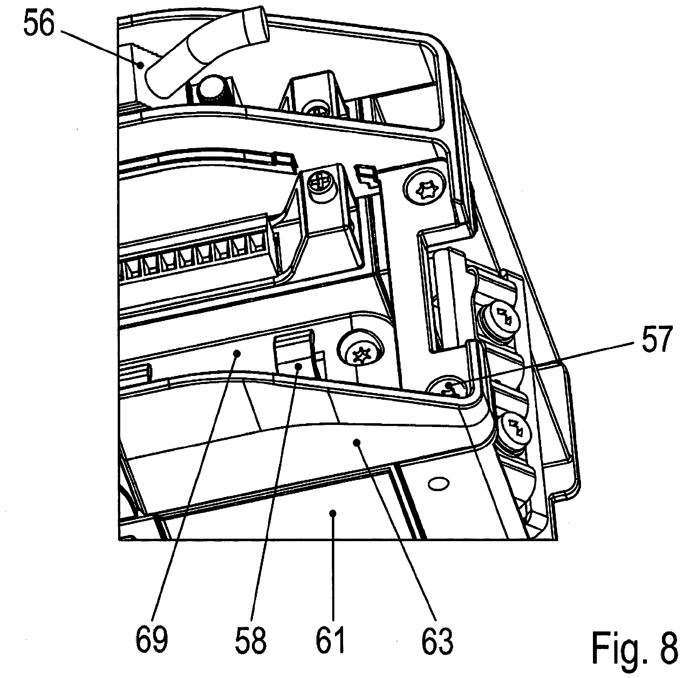

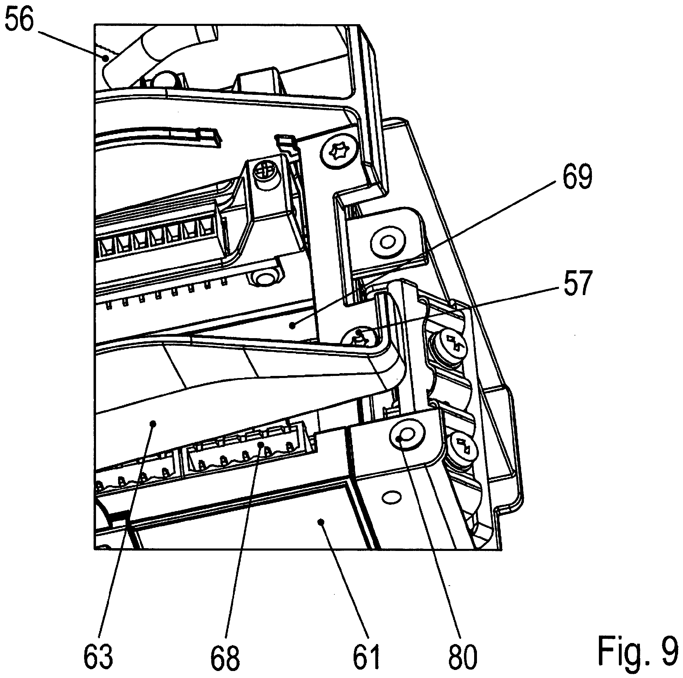

Ein in den Figuren 6 bis 9 dargestelltes zweites Ausführungsbeispiel des Elektrogerätes, insbesondere ein Umrichter 49, weist ein Deckelteil 63 und ein zumindest ein Gehäuseteil 67 aufweisendes Gehäuse auf. Das Deckelteil 63 ist schwenkbar an dem Gehäuseteil 67 angeordnet.

Das Deckelteil 63 weist einen Gelenkabschnitt 65 auf, an dem ein Zapfen 50 angeordnet ist. Vorzugsweise fungiert der Zapfen 50 als Gelenkkopf. An dem Gehäuseteil 67 ist eine Gelenkaufnahme 71 ausgeführt, die einen Lagerabschnitt 51 aufweist. Der Zapfen 50 ist in dem Lagerabschnitt 51 gelagert.

Der Zapfen 50 ist kreiszylindrisch ausgeführt und weist eine kreisförmige Grundfläche auf. Der Lagerabschnitt 51 weist in Querrichtung zur Schwenkachse des Deckelteils 63 eine Öffnung auf, vorzugsweise ist der Lagerabschnitt 51 U-förmig ausgeführt. Durch die Öffnung ist der Zapfen 50 in den Lagerabschnitt 51 einführbar.

Vorzugsweise ist das Gehäuse mehrteilig ausgeführt und weist Gehäuseteile (61, 67) aus Kunststoff und/oder aus metallischem Material auf, beispielsweise Aluminium. Vorzugsweise ist das Deckelteil 63 ein Kunststoffteil, vorzugsweise ein Kunststoffspritzgussteil.

Das Deckelteil 63 ist lösbar mit dem Gehäuseteil 67 verbindbar.

Vorzugsweise weist das Deckelteil 63 zwei parallel zur Schwenkachse angeordnete Zapfen 50 auf, die in zwei entsprechenden Lagerabschnitten 51 des Gehäuseteils 67 anordenbar sind.

Das Deckelteil 63 ist mit einem weiteren Gehäuseteil 61 des Gehäuses lösbar verbindbar mittels eines Verbindungsmittels 57, insbesondere eines Schraubteils. Dazu ist das Verbindungsmittel 57 teilweise durch eine Ausnehmung in dem Deckelteil 63 geführt und mit dem Gehäuseteil 61 schraubverbunden. Das Gehäuseteil 61 weist ein weiteres Verbindungsmittel 80, insbesondere Gewindeteil, auf, mit dem das Verbindungsmittel 57 verbunden ist, insbesondere schraubverbunden.

Das Deckelteil 63 weist eine Ausnehmung auf, die mittels eines Abdeckteils 52 verschließbar ist. Das Abdeckteil 52 verdeckt das Verbindungsmittel 57, insbesondere Schraubteil. Das Abdeckteil 52 ist lösbar mit dem Deckelteil 63 verbunden, vorzugsweise klipsverbunden, insbesondere mittels eines Verbindungsmittels 54, insbesondere Klipsverbinder, verbunden. Der Umrichter 49 weist zumindest ein Steckverbinderteil 68 auf, insbesondere zur Verbindung mit einem Datenübertragungskabel. Das Steckverbinderteil 68 ist an einem Gehäuseteil 69 des Gehäuses angeordnet, das zumindest teilweise mittels des Abdeckteils 52 abdeckbar ist.

Die Steckverbinderteile (13, 21, 55, 56) sind vorzugweise als Buchsen ausgeführt.

An dem Gehäuseteil 69 ist zumindest eine Kabelführung 58 angeordnet.

Der Umrichter 49 weist ein Bedienteil 62 auf. Vorzugsweise ist das Bedienteil lösbar mit einem Gehäuseteil 59 des Umrichters 49 verbunden, vorzugsweise klipsverbunden, insbesondere mittels eines Verbindungsmittels 70, insbesondere Klipsverbinders. Das Bedienteil 62 weist ein Anzeigemittel, insbesondere Display, und Bedienelemente auf.

Vorzugsweise weist das Deckelteil 63 eine Ausnehmung 64 auf, durch die das Bedienteil 62 zumindest teilweise in das Deckelteil 63 hineinragt und/oder durch das Deckelteil 63 hindurchragt. Das Bedienteil 62 ist durch die Ausnehmung 64 hindurch bedienbar.

Das Deckelteil 63 weist eine weitere Ausnehmung 53 auf, vorzugsweise erstreckt sich die Ausnehmung 53 über die gesamte Länge des Deckelteils 63. Durch die Ausnehmung 53 ist zumindest ein Gegensteckverbinderteil 56 zur Verbindung mit einem Steckverbinderteil 55 des Umrichters 49 hindurchführbar.

Der Umrichter 49 weist ein Einschubführungsteil 60 für ein Typenschild 59 auf. Auf dem Typenschild 59 sind technische Informationen und Warnhinweise aufgebracht. Das Typenschild 59 ist in das Einschubführungsteil 60 einschiebbar und vom Benutzer entnehmbar, so dass die technischen Informationen und Warnhinweise lesbar sind. Vorteilhafterweise erstreckt sich das Einschubführungsteil 60 in einer von dem Gehäuseteil 61 aufgespannten Ebene.

Das Deckelteil 63 weist eine Nut 68 auf. Bei geschlossenem Deckelteil 63 ist das Typenschild 59 von der Nut 68 geführt in das Einschubführungsteil 60 einschiebbar und/oder in der Nut 68 aufgenommen.

Das Gehäuseteil 67 weist zumindest ein Steckverbinderteil 66 auf, insbesondere zur Verbindung mit einem Datenbus.

In einem weiteren nicht dargestellten Ausführungsbeispiel weist die erste Ausführungsform des Elektrogeräts ein Bedienteil 62 auf, wie es im zweiten Ausführungsbeispiel beschrieben ist.

In einem weiteren nicht dargestellten Ausführungsbeispiel weist die erste Ausführungsform des Elektrogeräts ein Deckelteil 4 und ein Abdeckteil 52 auf, wie sie im zweiten Ausführungsbeispiel beschrieben sind.

In einem weiteren nicht dargestellten Ausführungsbeispiel weist die erste Ausführungsform des Elektrogeräts ein Deckelteil 4 aufweisend Ausnehmungen (53, 64) auf, wie es im zweiten Ausführungsbeispiel beschrieben ist.

### Bezugszeichenliste

1 Umrichter
2 Ausnehmungen, insbesondere Lüftungsschlitze
3 Gelenkabschnitt
4 Deckelteil
5 Abdeckteil
6 Typenschild
7 Ausnehmung
8 Gegensteckverbinderteil, insbesondere elektrisches Gegensteckverbinderteil
9 Ausnehmung
10 Kabelführung
11 Gehäuseteil
12 Einschubführungsteil
13 Steckverbinderteil, insbesondere elektrisches Steckverbinderteil
14 Gehäuseteil
15 Nut
20 Vorsprung
21 Steckverbinderteil, insbesondere elektrisches Steckverbinderteil
22 Kabel
23 Verriegelungsmittel
24 Verriegelungsmittel
25 Gehäuseteil
26 Kabelführung
30 Zapfen
31 Lagerabschnitt
32 Gelenkaufnahme
40 Nasenabschnitt
41 Begrenzungsmittel
42 Verbreiterungsabschnitt
49 Umrichter
50 Zapfen
51 Lagerabschnitt
52 Abdeckteil
53 Ausnehmung
54 Verbindungsmittel, insbesondere Klipsverbinder
55 Steckverbinderteil, insbesondere elektrisches Steckverbinderteil
56 Gegensteckverbinderteil, insbesondere elektrisches Gegensteckverbinderteil
57 Verbindungsmittel, insbesondere Schraubteil
58 Kabelführung
59 Typenschild
60 Einschubführungsteil
61 Gehäuseteil
62 Bedienteil
63 Deckelteil
64 Ausnehmung
65 Gelenkabschnitt
66 Steckverbinderteil, insbesondere elektrisches Steckverbinderteil
67 Gehäuseteil
68 Nut
70 Verbindungsmittel, insbesondere Klipsverbinder
71 Gelenkaufnahme
80 Verbindungsmittel, insbesondere Gewindeteil

## Patentansprüche

1. Elektrogerät, insbesondere Umrichter (1), aufweisend ein Gehäuse und ein Deckelteil (4),
**wobei** das Deckelteil (4) an dem Gehäuse des Elektrogerätes schwenkbar gelagert ist,
wobei das Deckelteil (4) in einer ersten Schwenkwinkelposition lösbar ist vom Gehäuse, wobei das Deckelteil (4) in einer zweiten Schwenkwinkelposition verriegelbar ist am Gehäuse,
indem das Deckelteil (4) einen Zapfen (30) aufweist, der in einem Lagerabschnitt (31), insbesondere einer Vertiefung, des Gehäuses aufgenommen ist,
wobei der Zapfen (30) in einer Querrichtung zur Schwenkachsrichtung weiter ausgedehnt ausgeformt ist als in einer zur Querrichtung und zur Schwenkachsrichtung senkrechten Richtung,
**dadurch gekennzeichnet, dass**
**das Gehäuse ein Einschubführungsteil (12) aufweist, in das ein Typenschild (6) einschiebbar ist,**
**wobei das Deckelteil (4) eine Nut (15) aufweist,**
**wobei in der zweiten Schwenkwinkelposition das Typenschild (6) in der Nut (15) angeordnet, insbesondere aufgenommen, ist,**
**wobei in der zweiten Schwenkwinkelposition das Typenschild (6) von der Nut (15) geführt in das Einschubführungsteil (12) einschiebbar und in der Nut (15) aufgenommen ist.**

2. Elektrogerät nach mindestens einem der vorangegangenen Ansprüche,
**dadurch gekennzeichnet, dass**
der Lagerabschnitt (31) einen Einführbereich und einen Drehbereich aufweist,
wobei der Zapfen (30) in der Querrichtung weiter ausgedehnt ist als der Einführbereich in einer zu einer Einführrichtung des Einführbereichs senkrechten Richtung,
wobei in der ersten Schwenkwinkelposition die Querrichtung des Zapfens (30) parallel ist zur Einführrichtung,
insbesondere wobei der Drehbereich als runde Vertiefung ausgeführt ist,
insbesondere wobei der Drehbereich sich radial weiter erstreckt als der Einführbereich in der zur Einführrichtung senkrechten Richtung.

3. Elektrogerät nach mindestens einem der vorangegangenen Ansprüche,
**dadurch gekennzeichnet, dass**
der Einführbereich in der Einführrichtung zum Drehbereich hin und zur Umgebung hin offen ausgeführt ist.

4. Elektrogerät nach mindestens einem der vorangegangenen Ansprüche,
**dadurch gekennzeichnet, dass**
das Deckelteil (4) einen Grundkörper und einen Gelenkabschnitt (3) aufweist, der aus dem Grundkörper auskragt,
wobei der Zapfen (30) an dem Gelenkabschnitt (3) angeordnet ist und beabstandet ist vom Grundkörper,
insbesondere wobei Grundkörper, Zapfen (30) und Gelenkabschnitt (3) einstückig ausgeführt sind, insbesondere als Kunststoffspritzgussteil.

5. Elektrogerät nach mindestens einem der vorangegangenen Ansprüche,
**dadurch gekennzeichnet, dass**
das Gehäuse eine Gelenkaufnahme (32) aufweist,
wobei der Gelenkabschnitt (3) des Deckelteils (4) in der Gelenkaufnahme (32) aufgenommen ist und in axialer Richtung begrenzt ist von der Gelenkaufnahme (32),
insbesondere wobei der Lagerabschnitt (31) als Vertiefung in der Gelenkaufnahme (32) ausgeführt ist,
insbesondere wobei die Gelenkaufnahme (32) als gestufte Vertiefung ausgeführt ist.

6. Elektrogerät nach mindestens einem der vorangegangenen Ansprüche,
**dadurch gekennzeichnet, dass**
das Elektrogerät ein Verriegelungsmittel (23) zum Verriegeln des Deckelteils (4) aufweist, insbesondere wobei das Deckelteil (4) verriegelbar ist am Gehäuse mittels des Verriegelungsmittels (23).

7. Elektrogerät nach mindestens einem der vorangegangenen Ansprüche,
**dadurch gekennzeichnet, dass**
das Verriegelungsmittel (23) am Gehäuse drehbar gelagert ist um eine Drehachse,
wobei das Verriegelungsmittel (23) einen Verbreiterungsabschnitt (42) aufweist,
der unrund ausgeführt ist, insbesondere also einen, insbesondere exzentrisch zur drehbaren Lagerung des Verriegelungsmittels (23) am Gehäuse, herausragenden Nasenabschnitt (40) aufweist, der beabstandet ist vom Gehäuse.

8. Elektrogerät nach mindestens einem der vorangegangenen Ansprüche,
**dadurch gekennzeichnet, dass**
das Verriegelungsmittel (23) zumindest in eine erste oder eine zweite Position drehbar ist,
wobei das Deckelteil (4) in der ersten Position des Verriegelungsmittels (23) verriegelt ist und wobei das Deckelteil (4) in der zweiten Position des Verriegelungsmittels (23) entriegelt ist.

9. Elektrogerät nach mindestens einem der vorangegangenen Ansprüche,
**dadurch gekennzeichnet, dass**
am Gehäuse und/oder dem Deckelteil (4) zumindest ein Begrenzungsmittel (41) ausgeformt oder verbunden ist, welches die Drehbewegung des Verriegelungsmittels (23) in beziehungswiese entgegen der Umfangsrichtung begrenzt.

10. Elektrogerät nach mindestens einem der vorangegangenen Ansprüche,
**dadurch gekennzeichnet, dass**
das Gehäuse und/oder das Deckelteil (4) ein erstes Begrenzungsmittel (41) aufweist,
wobei das Verriegelungsmittel (23) in der ersten Position von dem ersten Begrenzungsmittel (41) begrenzt ist,
und/oder dass
das Gehäuse und/oder das Deckelteil (4) ein zweites Begrenzungsmittel (41) aufweist,
wobei das Verriegelungsmittel (23) in der zweiten Position von dem zweiten Begrenzungsmittel (41) begrenzt ist,
insbesondere wobei das erste und zweite Begrenzungsmittel (41) einstückig ausgeführt sind.

11. Elektrogerät nach mindestens einem der vorangegangenen Ansprüche,
**dadurch gekennzeichnet, dass**
das Verriegelungsmittel (23) in einer ersten Drehrichtung in die erste Position verdrehbar ist und in einer zweiten Drehrichtung in die zweite Position verdrehbar ist,
wobei die erste und zweite Drehrichtung einander entgegengesetzt sind.

12. Elektrogerät nach mindestens einem der vorangegangenen Ansprüche,
**dadurch gekennzeichnet, dass**
das Deckelteil (4) einen Vorsprung (20) aufweist,
wobei der Vorsprung (20) in der ersten Position des Verriegelungsmittels (23) zumindest teilweise zwischen dem Gehäuse und dem Nasenabschnitt (40) angeordnet ist,
und/oder wobei in der ersten Position des Verriegelungsmittels (23) die axiale Projektion des Nasenabschnitts (40) relativ zur Drehachse des Verriegelungsmittels (23), die axiale Projektion des Vorsprungs (20) relativ zur Drehachse des Verriegelungsmittels (23) zumindest teilweise überdeckt,
insbesondere wobei der Vorsprung (20) in der zweiten Position des Verriegelungsmittels (23) von dem Nasenabschnitt (40) in radialer Richtung relativ zur Drehachse des Verriegelungsmittels (23) beabstandet ist.

13. Elektrogerät nach mindestens einem der vorangegangenen Ansprüche,
**dadurch gekennzeichnet, dass**
das Deckelteil (4) eine erste Ausnehmung aufweist, die mit einem Abdeckteil (52) verschließbar ist,
wobei das Deckelteil (4) mit dem Abdeckteil (52) lösbar verbunden ist, insbesondere klipsverbunden,
wobei das Abdeckteil (52) in der zweiten Schwenkwinkelposition das Verriegelungsmittel (23) abdeckt,
insbesondere wobei das Abdeckteil (52) in der zweiten Schwenkwinkelposition ein Steckverbinderteil (55) abdeckt.

14. Elektrogerät nach mindestens einem der vorangegangenen Ansprüche, **dadurch gekennzeichnet, dass**
ein Gehäuseteil (11) des Gehäuses mit dem Einschubführungsteil (12) verbunden ist, wobei das Gehäuseteil (11) als Metallteil ausgeführt ist und/oder das Typenschild (6) und/oder das Einschubführungsteil (12) als Kunststoffteil ausgeführt sind.

15. Elektrogerät nach mindestens einem der vorangegangenen Ansprüche,
**dadurch gekennzeichnet, dass**
ein Bedienteil (62) lösbar mit dem Gehäuse verbunden ist, insbesondere klipsverbunden,
wobei das Deckelteil (4) eine zweite Ausnehmung (64) aufweist, durch die das Bedienteil (62) hindurchbedienbar ist,
wobei das Deckelteil (4) das Bedienteil (62) am Gehäuse sichert, insbesondere hält,
und/oder dass
das Deckelteil (4) eine dritte Ausnehmung (53) aufweist,
wobei am Elektrogerät ein weiteres Steckverbinderteil angeordnet ist, das durch die dritte Ausnehmung (53) hindurch zugänglich ist, insbesondere für ein Gegensteckverbinderteil (56), insbesondere so dass das Gegensteckverbinderteil (56) zur Verbindung mit dem weiteren Steckverbinderteil durch die dritte Ausnehmung (53) hindurch führbar ist und steckverbindbar ist mit dem Steckverbinderteil, insbesondere in der zweiten Schwenkwinkelposition.

## Claims

1. Electrical device, in particular a converter (1), having a housing and a cover part (4),
wherein the cover part (4) is pivotably mounted on the housing of the electrical device,
wherein the cover part (4), in a first pivot angle position, is detachable from the housing,
wherein the cover part (4), in a second pivot angle position, can be locked onto the housing,
by the cover part (4) having a pin (30) which is received in a bearing portion (31), in particular a depression, of the housing,
wherein the pin (30) is shaped so as to be extended further in a transverse direction with respect to the pivot axis direction than in a direction perpendicular to the transverse direction and to the pivot axis direction,
**characterized in that**
the housing has an insertion guide part (12), into which a rating plate (6) can be inserted,
wherein the cover part (4) has a groove (15),
wherein, in the second pivot angle position, the rating plate (6) is arranged in the groove (15), in particular is accommodated therein,
wherein, in the second pivot angle position, the rating plate (6) can be inserted into the insertion guide part (12) in a manner guided by the groove (15) and is accommodated in the groove (15).

2. Electrical device according to at least one of the preceding claims,
**characterized in that**
the bearing portion (31) has an introduction region and a rotation region,
wherein the pin (30) is extended further in the transverse direction than the introduction region in a direction perpendicular to an introduction direction of the introduction region,
wherein, in the first pivot angle position, the transverse direction of the pin (30) is parallel to the introduction direction,
in particular wherein the rotation region is configured as a round depression,
in particular wherein the rotation region extends further in the radial direction than the introduction region in the direction perpendicular to the introduction direction.

3. Electrical device according to at least one of the preceding claims,
**characterized in that**
the introduction region is open in the introduction direction towards the rotation region and towards the surrounding environment.

4. Electrical device according to at least one of the preceding claims,
**characterized in that**
the cover part (4) has a main body and a hinge portion (3) which projects from the main body,
wherein the pin (30) is arranged on the hinge portion (3) and is spaced apart from the main body,
in particular wherein the main body, the pin (30) and the hinge portion (3) are made in one piece, in particular as an injection-moulded plastic part.

5. Electrical device according to at least one of the preceding claims,
**characterized in that**
the housing has a hinge receiving area (32),
wherein the hinge portion (3) of the cover part (4) is received in the hinge receiving area (32) and is bounded in the axial direction by the hinge receiving area (32),
in particular wherein the bearing portion (31) is configured as a depression in the hinge receiving area (32),
in particular wherein the hinge receiving area (32) is configured as a stepped depression.

6. Electrical device according to at least one of the preceding claims,
**characterized in that**
the electrical device has a locking means (23) for locking the cover part (4),
in particular wherein the cover part (4) can be locked onto the housing by way of the locking means (23).

7. Electrical device according to at least one of the preceding claims,
**characterized in that**
the locking means (23) is mounted on the housing such as to be rotatable about an axis of rotation,
wherein the locking means (23) has a widened portion (42), which is non-round, that is to say in particular has a lug portion (40) which is spaced apart from the housing and which projects in particular eccentrically with respect to the rotatable mounting of the locking means (23) on the housing.

8. Electrical device according to at least one of the preceding claims,
**characterized in that**
the locking means (23) can be rotated at least into a first or a second position,
wherein the cover part (4) is locked in the first position of the locking means (23), and
wherein the cover part (4) is unlocked in the second position of the locking means (23).

9. Electrical device according to at least one of the preceding claims,
**characterized in that**
at least one limiting means (41) is formed on or connected to the housing and/or the cover part (4), which limiting means limits the rotational movement of the locking means (23) in or counter to the circumferential direction.

10. Electrical device according to at least one of the preceding claims,
**characterized in that**
the housing and/or the cover part (4) has a first limiting means (41),
wherein the locking means (23) in the first position is limited by the first limiting means (41),
and/or **in that**
the housing and/or the cover part (4) has a second limiting means (41),
wherein the locking means (23) in the second position is limited by the second limiting means (41),
in particular wherein the first and second limiting means (41) are made in one piece.

11. Electrical device according to at least one of the preceding claims,
**characterized in that**
the locking means (23) can be rotated in a first direction of rotation into the first position and can be rotated in a second direction of rotation into the second position,
wherein the first and second directions of rotation are opposite to one another.

12. Electrical device according to at least one of the preceding claims,
**characterized in that**
the cover part (4) has a protrusion (20),
wherein, in the first position of the locking means (23), the protrusion (20) is arranged at least partially between the housing and the lug portion (40),
and/or wherein, in the first position of the locking means (23), the axial projection of the lug portion (40) relative to the axis of rotation of the locking means (23) at least partially overlaps the axial projection of the protrusion (20) relative to the axis of rotation of the locking means (23),
in particular wherein, in the second position of the locking means (23), the protrusion (20) is spaced apart from the lug portion (40) in the radial direction relative to the axis of rotation of the locking means (23).

13. Electrical device according to at least one of the preceding claims,
**characterized in that**
the cover part (4) has a first cutout, which can be closed by a covering part (52),
wherein the cover part (4) is detachably connected to the covering part (52), in particular is clip-connected thereto, wherein the covering part (52) covers the locking means (23) in the second pivot angle position,
in particular wherein the covering part (52) covers a plug connector part (55) in the second pivot angle position.

14. Electrical device according to at least one of the preceding claims,
**characterized in that**
a housing part (11) of the housing is connected to the insertion guide part (12), wherein the housing part (11) is configured as a metal part and/or the rating plate (6) and/or the insertion guide part (12) are configured as a plastic part.

15. Electrical device according to at least one of the preceding claims,
**characterized in that**
an operating part (62) is detachably connected to the housing, in particular is clip-connected thereto,
wherein the cover part (4) has a second cutout (64), through which the operating part (62) can be operated,
wherein the cover part (4) secures the operating part (62) to the housing, in particular holds it thereon,
and/or **in that**
the cover part (4) has a third cutout (53),
wherein a further plug connector part is arranged on the electrical device, which further plug connector part is accessible through the third cutout (53), in particular for a mating plug connector part (56), in particular so that the mating plug connector part (56) can be guided through the third cutout (53) in order to be connected to the further plug connector part and can be plugged into the plug connector part, in particular in the second pivot angle position.

## Revendications

1. Appareil électrique, en particulier convertisseur (1), présentant un boîtier et un élément formant couvercle (4),
sachant que l'élément formant couvercle (4) est monté à pivotement sur le boîtier de l'appareil électrique,
sachant que l'élément formant couvercle (4) peut être retiré du boîtier dans une première position angulaire de pivotement,
sachant que l'élément formant couvercle (4) peut être verrouillé sur le boîtier dans une deuxième position angulaire de pivotement,
par le fait que l'élément formant couvercle (4) présente un tenon (30), qui est reçu dans une partie formant palier (31), en particulier un renfoncement, du boîtier,
sachant que le tenon (30) est façonné davantage étendu dans une direction transversale à la direction de l'axe de pivotement que dans une direction perpendiculaire à la direction transversale et à la direction de l'axe de pivotement,
**caractérisé en ce que** le boîtier présente un élément (12) formant guide d'insertion, dans lequel peut être insérée une plaque signalétique (6),
sachant que l'élément formant couvercle (4) présente une rainure (15),
sachant que, dans la deuxième position angulaire de pivotement, la plaque signalétique (6) est disposée, en particulier est reçue, dans la rainure (15),
sachant que, dans la deuxième position angulaire de pivotement, la plaque signalétique (6) peut être insérée dans l'élément (12) formant guide d'insertion en étant guidée par la rainure (15) et est reçue dans la rainure (15).

2. Appareil électrique selon la revendication 1, **caractérisé en ce que** la partie formant palier (31) présente une région d'introduction et une région de rotation,
sachant que le tenon (30) est davantage étendu dans la direction transversale que la région d'introduction dans une direction perpendiculaire à une direction d'introduction de la région d'introduction,
sachant que, dans la première position angulaire de pivotement, la direction transversale du tenon (30) est parallèle à la direction d'introduction,
sachant en particulier que la région de rotation est réalisée sous forme de renfoncement rond,
sachant en particulier que la région de rotation s'étend davantage radialement que la région d'introduction dans la direction perpendiculaire à la direction d'introduction.

3. Appareil électrique selon au moins une des revendications précédentes, **caractérisé en ce que** la région d'introduction est réalisée ouverte dans la direction d'introduction vers la région de rotation et vers l'environnement.

4. Appareil électrique selon au moins une des revendications précédentes, **caractérisé en ce que** l'élément formant couvercle (4) présente un corps de base et une partie d'articulation (3) qui fait saillie hors du corps de base,
sachant que le tenon (30) est disposé sur la partie d'articulation (3) et est distant du corps de base,
sachant en particulier que le corps de base, le tenon (30) et la partie d'articulation (3) sont réalisés d'un seul tenant, en particulier sous forme de pièce en matière plastique moulée par injection.

5. Appareil électrique selon au moins une des revendications précédentes, **caractérisé en ce que** le boîtier présente un logement d'articulation (32),
sachant que la partie d'articulation (3) de l'élément formant couvercle (4) est reçue dans le logement d'articulation (32) et est limitée en direction axiale par le logement d'articulation (32),
sachant en particulier que la partie formant palier (31) est réalisée sous forme de renfoncement dans le logement d'articulation (32),
sachant en particulier que le logement d'articulation (32) est réalisé sous forme de renfoncement étagé.

6. Appareil électrique selon au moins une des revendications précédentes, **caractérisé en ce que** l'appareil électrique présente un moyen de verrouillage (23) destiné à verrouiller l'élément formant couvercle (4),
sachant en particulier que l'élément formant couvercle (4) peut être verrouillé sur le boîtier à l'aide du moyen de verrouillage (23).

7. Appareil électrique selon au moins une des revendications précédentes, **caractérisé en ce que** le moyen de verrouillage (23) est monté à rotation sur le boîtier autour d'un axe de rotation,
sachant que le moyen de verrouillage (23) présente une partie élargie (42) qui est réalisée ovalisée, en particulier donc présente une partie formant ergot (40) faisant saillie en particulier excentriquement au montage à rotation du moyen de verrouillage (23) sur le boîtier, partie qui est distante du boîtier.

8. Appareil électrique selon au moins une des revendications précédentes, **caractérisé en ce que** le moyen de verrouillage (23) est rotatif au moins dans une première ou une deuxième position,
sachant que l'élément formant couvercle (4) est verrouillé dans la première position du moyen de verrouillage (23) et
sachant que l'élément formant couvercle (4) est déverrouillé dans la deuxième position du moyen de verrouillage (23).

9. Appareil électrique selon au moins une des revendications précédentes, **caractérisé en ce qu'**au moins un moyen de limitation (41) est façonné sur ou relié au boîtier et/ou à l'élément formant couvercle (4), moyen qui limite le mouvement de rotation du moyen de verrouillage (23) dans le sens périphérique ou respectivement dans le sens opposé.

10. Appareil électrique selon au moins une des revendications précédentes, **caractérisé en ce que** le boîtier et/ou l'élément formant couvercle (4) présente un premier moyen de limitation (41),
sachant que le moyen de verrouillage (23) est limité par le premier moyen de limitation (41) dans la première position,
et/ou **en ce que** le boîtier et/ou l'élément formant couvercle (4) présente un deuxième moyen de limitation (41),
sachant que le moyen de verrouillage (23) est limité par le deuxième moyen de limitation (41) dans la deuxième position,
sachant en particulier que le premier et le deuxième moyens de limitation (41) sont réalisés d'un seul tenant.

11. Appareil électrique selon au moins une des revendications précédentes, **caractérisé en ce que** le moyen de verrouillage (23) peut être tourné dans la première position dans un premier sens de rotation et peut être tourné dans la deuxième position dans un deuxième sens de rotation,
sachant que le premier et le deuxième sens de rotation sont mutuellement opposés.

12. Appareil électrique selon au moins une des revendications précédentes, **caractérisé en ce que** l'élément formant couvercle (4) présente une saillie (20),
sachant que la saillie (20), dans la première position du moyen de verrouillage (23), est disposée au moins partiellement entre le boîtier et la partie formant ergot (40),
et/ou sachant que, dans la première position du moyen de verrouillage (23), la projection axiale de la partie formant ergot (40) par rapport à l'axe de rotation du moyen de verrouillage (23) couvre au moins partiellement la projection axiale de la saillie (20) par rapport à l'axe de rotation du moyen de verrouillage (23),
sachant en particulier que la saillie (20), dans la deuxième position du moyen de verrouillage (23), est distante de la partie formant ergot (40) en direction radiale par rapport à l'axe de rotation du moyen de verrouillage (23).

13. Appareil électrique selon au moins une des revendications précédentes, **caractérisé en ce que** l'élément formant couvercle (4) présente un premier évidement qui peut être fermé par un élément de recouvrement (52),
sachant que l'élément formant couvercle (4) est relié de manière amovible à l'élément de recouvrement (52), en particulier relié par clip,
sachant que l'élément de recouvrement (52) recouvre le moyen de verrouillage (23) dans la deuxième position angulaire de pivotement,
sachant en particulier que l'élément de recouvrement (52) recouvre un élément formant connecteur (55) dans la deuxième position angulaire de pivotement.

14. Appareil électrique selon au moins une des revendications précédentes, **caractérisé en ce qu'**un élément de boîtier (11) du boîtier est relié à l'élément (12) formant guide d'insertion, sachant que l'élément de boîtier (11) est réalisé sous forme d'élément en métal et/ou que la plaque signalétique (6) et/ou l'élément (12) formant guide d'insertion sont réalisés sous forme d'élément en matière plastique.

15. Appareil électrique selon au moins une des revendications précédentes, **caractérisé en ce qu'**un élément de manœuvre (62) est relié de manière amovible au boîtier, en particulier relié par clip,
sachant que l'élément formant couvercle (4) présente un deuxième évidement (64), à travers lequel l'élément de manœuvre (62) peut être manœuvré,
sachant que l'élément formant couvercle (4) assujettit, en particulier maintient, l'élément de manœuvre (62) sur le boîtier,
et/ou **en ce que** l'élément formant couvercle (4) présente un troisième évidement (53), sachant qu'un autre élément formant connecteur est disposé sur l'appareil électrique,
élément qui est accessible à travers le troisième évidement (53), en particulier pour un élément formant connecteur complémentaire (56), en particulier de sorte que l'élément formant connecteur complémentaire (56) peut, afin de le relier à l'autre élément formant connecteur, être dirigé à travers le troisième évidement (53) et être relié par enfichage à l'élément formant connecteur, en particulier dans la deuxième position angulaire de pivotement.
